Europäisches Patentamt

European Patent Office

Office européen des brevets

(11) Publication number: **0 441 567 A2**

# EUROPEAN PATENT APPLICATION

(21) Application number: 91300877.7

(51) Int. Cl.⁵: **G06K 11/16**

(22) Date of filing: 04.02.91

(30) Priority: 08.02.90 GB 9002783
25.10.90 GB 9023246

(43) Date of publication of application:
**14.08.91 Bulletin 91/33**

(84) Designated Contracting States:
**CH DE FR GB IT LI NL**

(71) Applicant: THORN EMI plc
**4 Tenterden Street**
**London W1A 2AY(GB)**

(72) Inventor: **Nix, Elvin Leonard**
**15A Addington Close**
**Windsor, Berkshire SL4 4BP(GB)**

Inventor: **Sibbald, Alastair**
**18 Horseguards Drive**
**Maidenhead, Berkshire SL6 1XL(GB)**
Inventor: **Holcroft, Brian**
**31 Parkview Court**
**High Wycombe, Buckinghamshire HP12**
**3AR(GB)**
Inventor: **Jackson, Brian**
**Midemede, 1 Westwell Lane, Theale**
**Wedmore, Somerset BS28 4SW(GB)**

(74) Representative: **Sorenti, Gino et al**
**THORN EMI Patents Limited, Central**
**Research Laboratories, Dawley Road**
**Hayes, Middlesex UB3 1HH(GB)**

(54) **Pressure sensitive device.**

(57) A pressure sensitive device may be used in the characterisation of written signatures and includes X- and a Y-coordinate piezoelectric layers (11,5) overlying which are, respectively, X- and Y- coordinate electrode structures (13,3). As pressure from a stylus is applied to the coordinate electrode structures (13,3) the piezoelectric layers (11,5) generate signals indicative of the coordinate position of the stylus on the device. The device further includes a pressure pad active device (29) for providing data indicative of the pressure applied to the device by the stylus.

FIG.1

**"PRESSURE SENSITIVE DEVICE"**

This invention relates to pressure sensitive devices and has particular although not exclusive relevance to pressure sensitive devices designed to operate as the sensor component of a dynamic signature verification system such as might be used for example at a point of sale terminal.

One pressure sensitive device suitable for use in a signature verification system is described in an article in Proceedings of the 1988 International Carnahan Conference on Security Technology : Crime Countermeasures (IEEE) October 5-7 (1988) by P. de Bruyne. The device described comprises two superimposed piezoelectric membranes. On each membrane there are etched an interleaved pattern of electrodes connected to a pair of common busbars, the electrodes on the upper membrane running along the length of the membrane and the electrodes on the lower membrane running parallel to the breadth of the membrane. Thus one membrane registers speed profiles of imposed handwriting with motion in the direction parallel to the length of the device whilst the other membrane monitors speed profiles in the orthogonal direction parallel to the breadth of the device. Such a device suffers the disadvantage however that it only measures speed profiles and, it is not possible to deduce the exact coordinates of a stylus on the device at any point in time. Furthermore the device is not sensitive to variations in stylus pressure as the signature is made.

It is an object of the present invention to provide a pressure sensitive device which is suitable for use in a dynamic signature verification system wherein the above shortcomings are at least alleviated.

According to the present invention a pressure sensitive device comprises a piezoelectric member, and at least one co-ordinate electrode structure carried on the member, each electrode structure comprising an array of strips, a common electrode structure carried by the member and data collection means comprising a plurality of busbars providing electrical connections to selected ones of the strips such that the coordinates of a point pressure applied on the device may be determined by piezoelectrical signals derived from the busbars.

Preferably there are first and second co-ordinate electrode structures, the strips within each of the co-ordinate electrode structures being parallel, the strips of the first and second co-ordinate electrode structures extending in different directions over the member. By such an arrangement both the X and Y co-ordinates of the pressure may be determined.

The busbars may be connected to the selected strips via a selection of resistive members of predetermined resistance, the values of the selection of resistive members being so as divide the strips between the busbars in a binary manner.

The piezoelectric member may comprise two superimposed piezoelectric layers, each carrying one of the first and second co-ordinate electrode structures.

Alternatively the piezoelectric member may comprise a single piezoelectric layer. The device suitably includes means for determining the magnitude of the point pressure from the piezoelectric signals.

Alternatively or additionally the device may also include a further piezoelectric member, with a third electrode structure carried by the further member, the further member being arranged to produce piezoelectric signals representative of the magnitude of the point pressure.

Three pressure sensitive devices in accordance with the invention, together with methods of making the devices will now be described by way of example only, with reference to the accompanying figures in which:-

Figure 1 is a schematic plan view of the first device;

Figure 2 is an exploded sectional view along line A-A of the first device;

Figure 3 is a schematic plan view of part of the electrode structure of the first device for a particular implementation where the piezoelectric signals are encoded prior to charge integration;

Figure 4 shows part of the circuitry incorporated in the first device;

Figures 5, 6, 7 and 8 show alternative electrode geometries which may be incorporated in devices in accordance with the invention;

Figure 9 is a plan view of a single co-ordinate-pair sensing element and one associated resistive link of the second device;

Figure 10 is a section along the line B-B of the device shown in Figure 9;

Figure 11 is a sectional view, corresponding to the view of Figure 10, of a modification of the second device;

Figure 12 is a plan view of the X and Y electrode arrays of the device of Figure 11; and

Figure 13 shows a schematic representation of a communications link utlising the present invention.

Figure 14 illustrates a method of displaying the information generated by a pressure sensitive device in accordance with the invention.

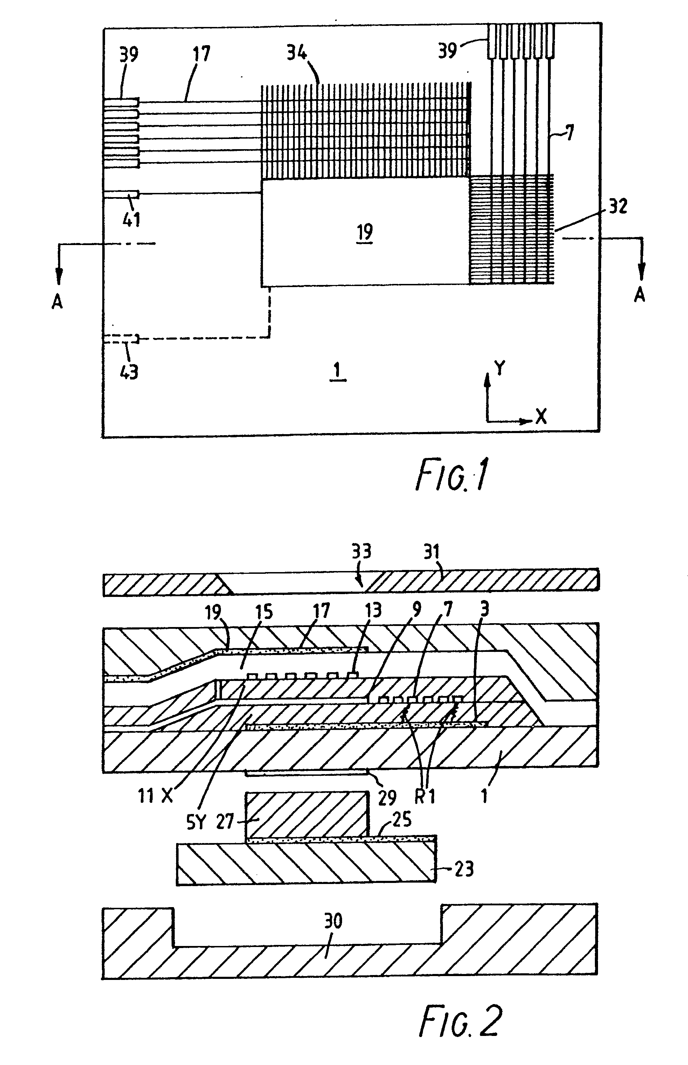

Referring firstly to Figures 1 and 2 the first device to be described comprises an insulating substrate 1 e.g. glass, alumina, epoxy etc., over which is formed a conducting Y-coordinate electrode structure 3 comprising an array of parallel sensing electrodes. Overlying and partially extending beyond the electrode 3 there is formed a Y-coordinate piezoelectric layer 5. This layer may be formed from any suitable material, for example vinylidene fluoride/trifluoroethylene copolymer (VDF/TrFE) or a composite piezoelectric material. Overlying part of the Y-coordinate piezoelectric layer 5 there is formed an array of Y-coordinate binary format analogue readout lines 7, an X-Y-coordinate common electrode 9 also being formed over the layer 5 to extend on to the insulating substrate 1. Overlying the common electrode 9, the Y-coordinate binary format analogue readout lines 7 and the exposed regions of the Y-coordinate piezoelectric layer 5, there is formed a X-coordinate piezoelectric layer 11. This layer 11 is also formed from any suitable piezoelectric material. Overlying the X-coordinate layer 11 there is formed an X-coordinate electrode structure 13 comprising an array of parallel sensing electrodes running parallel to the Y-coordinate binary format analogue readout lines but displaced therefrom so that they overlie the common electrode 9. An insulating layer 15 for example, polyimide overlies the X-coordinate electrode structure 13 and the exposed regions of the X-coordinate piezoelectric layer 11. An array of X-coordinate binary format analogue readout lines 17 running parallel to the Y-coordinate sensing electrodes 3 overlies the region of the polyimide insulating layer 15 corresponding to the position of the extensions of the X-coordinate electrode structure 34 of Figure 1. A protective layer and earth screen 19 encapsulates the upper surface of the device as so far described.

The device also incorporates a further pressure sensor including a substrate 23 over which is formed a pressure pad common electrode 25. Overlying the pressure pad common electrode 25 is a further piezoelectric pressure sensor 27 formed from a suitable piezoelectric material. The structure 23, 25, 27 is spaced from the exposed surface of the insulating substrate 1, underlying a pressure pad active electrode 29 carried on the exposed surface of the insulating substrate 1, at a position corresponding to that of the X and Y co-ordinate electrode structures 13 and 3. The whole device is enclosed within a device support frame 30 at the lower part of the device, and a cover plate 31 at the upper surface of the device. A window 33 is formed in the cover plate aligned with the active electrodes 13, 3, 29, 9 and 25, this window defining the area on which the signature being verified will be written using a suitable stylus.

Referring now particularly to Figure 1, electrode extension lines 32, 34 in the form of conductive tracks extend across the insulating substrate 1 respectively in the X and Y directions indicated in Figure 1, the lines 32 being connected to the X-coordinate electrode structure array 3 of Figure 2, and the lines 34 being connected to the Y coordinate electrode structure array 13 of Figure 2. The lines 32, 34 are overlaid by an insulating film of, for example polyimide or VDF/TrFE copolymer. X and Y binary format analogue readout lines 7, 17 cross the insulating film in the region of the electrode extension lines 32, 34 respectively to connect the lines 32, 34 to a series of edge connectors 39 as will be further explained hereafter. Further conductive tracks extend across the substrate to provide an electrical connection between the pressure pad active electrode 29 and respective edge connectors 41, 43.

In the device described above the piezoelectric layers 5, 11 and 27 operate together to provide electrical signals which characterise the dynamics and profile of a signature written with an ordinary writing stylus. The device is sensitive to the position of the stylus due to the upper two piezoelectric layers 5, 11 which provide electrical signals which allow the X and Y coordinates of the stylus to be determined as a function of the time elapsing after the commencement of the signature. The lower piezoelectric layer 27 provides a signal proportional to the pressure exerted by the stylus on the device as a function of time.

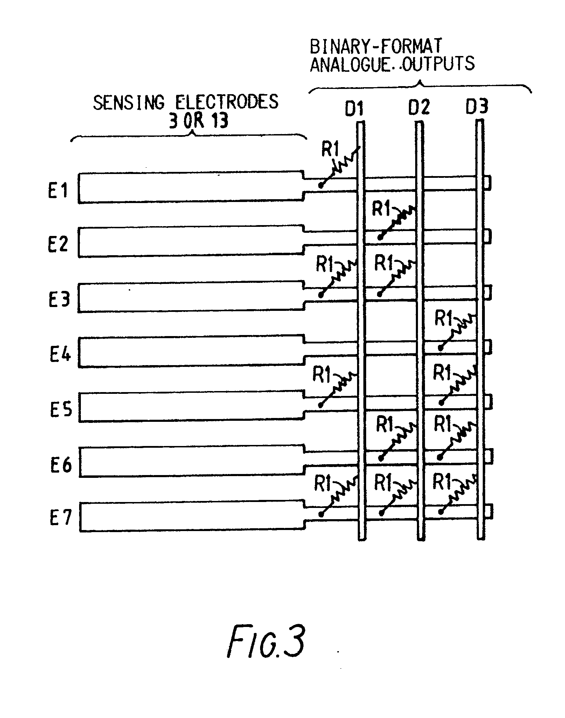

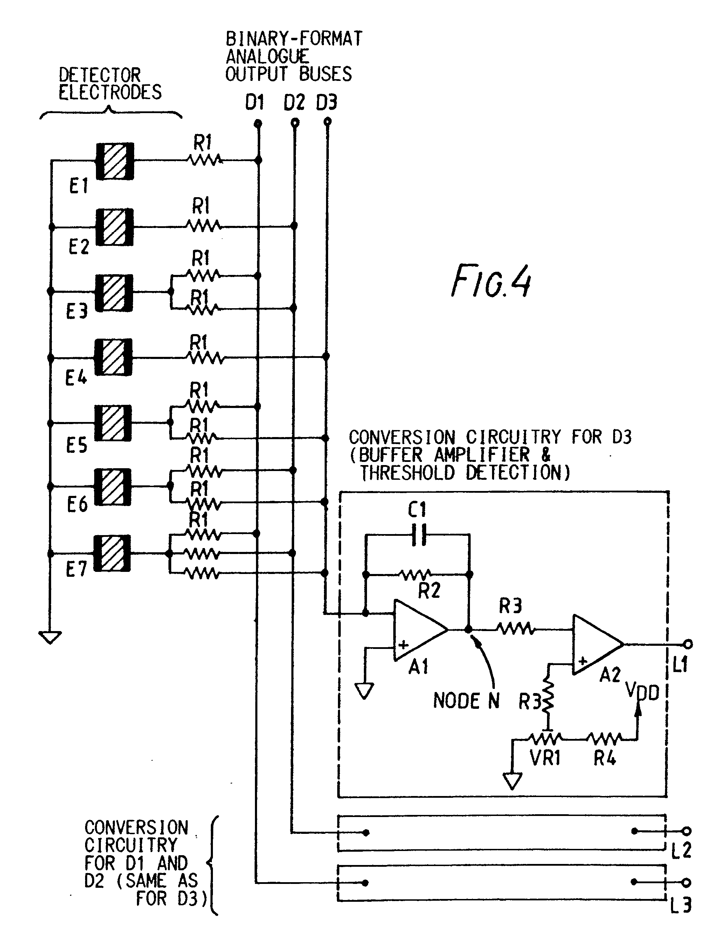

The interfacing circuitry for the device is designed to minimize the number of electrical connections which need to be provided to the electrode structures 3, 13, and to provide a direct quasi-digital output of both the X and Y coordinates of a stylus on the device. This is achieved by means of the circuitry illustrated in Figures 3 and 4, where only a seven element linear array of electrodes is shown for the sake of clarity although it will be appreciated that normally there will be many more electrodes.

The sensing electrodes E1 to E7 of each electrode structure 3 or 13 is connected via its extension 32 or 34 and an electrical resistor or resistors R1, to one or more of the overlying output busbars within the arrays 7 or 17 through holes in the intermediate insulating layer. The connection is done in a binary-weighted manner, as shown, ie, the busbar D1 is connected to electrodes E1, E3, E5 and E7; busbar D2 is connected to E2, E3, E6 and E7; and busbar D3 is connected to E4, E5, E6 and E7 etc. It will be seen that in view of the binary-weighted connections only three X or Y coordinate busbars are required to identify which electrode E1 to E7 is associated with a detected piezoelectric signal. Each row of pixels corresponding to electrodes E1 to E7 of the sensing area of the device is of course defined by the area under each of the sensing electrodes in the X and Y arrays 13, 3.

Referring now particularly to Figure 4 each busbar D1 to D3 is connected to the virtual earth port of an integrating operational amplifier A1, thus ensuring that the electrode-lines do not drive each other. Each of the amplifiers A1 is thus driven by one or more electrodes E1 to E7, and the output signal at node N is the summation of the individual electrode signals. However, by the nature of the system, only one electrode per array 3, 13 is activated by piezoelectric signals produced by the action of the stylus on the device at any particular instant, and therefore the amplifiers A1 effectively provide an "OR" function.

The piezoelectric charge generated by the application of a force on for example a single Y sensing electrode will be immediately transferred from the sensing electrode to the virtual earth of the charge integrating operational amplifier A1. The time-constant for this charge transfer will be governed by the capacitance of the sensing electrode, and the value of the resistance R1, this being typically 100 Kohms resulting in a time constant of the order of 10 ms. If the voltage at each output L1, L2, L3 is read every 1ms for example, it will be necessary to retain the piezoelectric charge on the feedback capacitor C1 of the amplifier A1 for approximately 10 ms. A value of 100 pF for C1, with a parallel feedback resister R2 of 100 Mohms providing some auto-zeroing capability will ensure a stable charge integration for the required period.

Each of the integrated signals produced at node N is fed into a voltage comparator A2 which has a predetermined threshold voltage, set by a potential divider chain comprising a series arrangement of a nominal, current-limiting resistor, of 10 kohms and variable resistor VR1. Ideally, the comparator A2 is chosen to incorporate a directly compatible TTL or CMOS output. Digital output data signals are therefore provided on output lines L1, L2 and L3.

It will be seen that the buffered output at node N of each of the amplifiers A1 will be modulated by the movement of the stylus across the sensor thus providing a transient signal relating to the pressure and position of the stylus. These signals could be rectified and summed so as to provide pressure and position information without the need for the separate pressure sensing structure 23, 25, 27, 29. Where the structure 23, 25, 27, 29 is incorporated however, it will be linked to a high impedance buffer amplifier (not shown) thus providing an analogue voltage proportional to pressure.

It will be appreciated that whilst it would be more expensive to provide respective buffer amplifier circuit between each electrode E1 to E7 and the respective resistive networks instead of the single circuit shown in Figure 4 where the piezoelectric signals are small, this would be advantageous.

The device shown in Figures 1 and 2 is fabricated as follows:

The Y-coordinate electrode structure 3 and its associated resistive elements, are formed by a suitable combination of standard thick- and thin-film processes on the substrate 1. Photolithographic or screen-printing processes, or electrodeless deposition, or a combination of these may be used. Alternatively the electrode structure 3 may be formed by etching a copper coated rigid or flexible printed circuit board (PCB). The overall dimensions of the substrate 1 will be typically 150 mm in the X-direction by 100 mm in the Y-direction to allow room for suitable connections from the sensing electrodes to the signal processing electronics. The electrode material thickness will be typically between 0.1 and 10 microns where thin-film processes are used, and greater than 10 microns where thick-film technology or etched copper technology is used. The Y-coordinate piezoelectric layer 5 is formed by spin-coating or screen-printing VDF/TrFE copolymer from solution by standard techniques to form a layer 10 microns to 100 microns thick. Alternatively, this layer could be formed in-situ by compression-moulding a composite piezoelectric typically 100 microns to 200 microns thick. The Y coordinate layer, and the corresponding X-coordinate piezoelectric layer could be considerably thicker, as long as the localized pressure of a writing stylus may be transmitted through both X and Y layers 5, 11 without significant spreading of the pressure to adjacent pixels in the XY plane. The uniformity of the thickness and anisotropy of the piezoelectric layer is not critical, provided the poling operation can be performed without electrical breakdown: In other words uniformity of piezoelectric response over the sensor area is not essential for the correct performance of the device in respect of sensing the XY coordinate location.

The X-Y coordinate common electrode 9 and its associated conductive track are formed by evaporation, screen-printing or other deposition means, of any suitable conducting material. This electrode will be separated at all points from the Y-coordinate electrode structure 3 by the VDF/TrFE copolymer layer 5. During the electrical poling operation (to be described below) the common electrode 9 will serve as the high-potential electrode, since it can be conveniently covered over its entire surface area by the copolymer.

The parallel conducting tracks for the Y-coordinate binary-format analogue output lines 7 are also created at this stage. Connections from the Y-coordinate sensing electrode structure 3 to the binary-format analogue outputs 7 will be made through the resistive elements shown, by means of holes in the Y-coordinate piezoelectric layer 5.

The X-coordinate piezoelectric layer 11 is formed in the same way as the Y-coordinate layer to be of similar thickness. This layer 11 could cover the entire insulating substrate 1 to form a protective layer, which would suitably encapsulate the Y-readout outputs.

The X-coordinate electrode structure 13 and its associated resistive elements, are then formed by a suitable photolithographic, screen-printing processes or PCB technology on the surface of the X-coordinate piezoelectric layer 11.

The insulating polyimide layer 15, typically 5 to 10 microns thick, is formed by spin-coating or screen-printing to cover the entire substrate, and in particular, to cover the X-coordinate sensing electrode structure 13 and its associated resistive elements.

The parallel conducting tracks for the X-coordinate binary-format analogue output 17 are created by a suitable combination of standard thick- and thin-film processes or by means of PCB technology. Connections from the X-coordinate electrode structure to the binary-format analogue outputs 17 are made through the resistive elements shown by means of holes in the polyimide layer 15.

The piezoelectric sensing layers 5 and 11 are then poled in a single poling operation by means of the application of a sufficiently high voltage to the common electrode 9, whilst the X and Y coordinate sensing electrode structures 3 and 13 are held at ground potential. This is a standard technique for poling ferroelectric polymer films or composite materials to render them piezoelectric.

The final protective layer 19 is then formed over the surface of the sensing area. This layer might be formed from a suitable epoxy and be combined with a conducting electrical screen. The protective layer will be sufficiently thin and compliant to transmit positional information from the writing stylus, and will have hard-wearing properties.

The pressure-sensing part of the device 23, 25, 27, 29 is formed separately as follows:

Firstly PVDF homopolymer piezoelectric layer 27 typically 100 to 500 microns thick is bonded to the conducting surface 25 of a suitably coated glass substrate 23 of dimensions equal to those of the XY-sensing piezoelectric area of the XY coordinate sensing device described above. The bond-layer will be suitably thin by comparison with the polymer layer (for example 1% or less of the pressure-sensing piezoelectric layer thickness), or, alternatively, be formed from a somewhat thicker conducting epoxy resin, in which case a preformed conducting surface is unnecessary.

The layer 27 and glass substrate 23 is then bonded by a suitable technique to the conducting under-surface 29 of the XY coordinate sensor assembly.

The composite piezoelectric assembly is then mounted into the holder 30 so that pressure can be transmitted from the top protective layer surface 19 formed on the device through the piezoelectric layers 5 and 11 to the PVDF homopolymer pressure-sensing layer 27.

Connections are then made from the patterned electrode layers, from the pressure-layer electrode and from the ground electrodes to the edge connectors 39, 41, 43 and, where suitable, bond wires are encapsulated. The whole assembly is then covered by the cover plate 31.

For a typical device, the X-coordinate electrode structure 13 consists of 127 parallel sensing electrodes with a pitch of 0.5 mm and an electrode width of 0.4 mm. The Y-coordinate electrode structure 3 consists of 63 parallel sensing electrodes with a pitch of 0.5 mm and an electrode width of 0.4 mm. These dimensions give an actual device length of approximately 63 mm and a device height of approximately 32 mm which are suitable dimensions to accommodate the length and height of a handwritten signature. The sensor's electrode spacings are suitable for the sensing of a writing stylus tip; higher resolution is of course possible with a finer electrode pitch.

A typical stylus will have a contact pressure area of approximately 200 microns and 200 microns, ensuring that when the stylus is "between" electrodes, both adjacent electrodes are activated. If the subsequent motion of the stylus is in the direction of the Y-coordinate axis, the charge integrating electronics will receive no further piezoelectric charge to compensate the charge decay in the feedback circuit, and therefore no further X-information will be available. This will be especially true (for pure Y-direction) when the stylus is in the centre of the 400 micron wide electrode.

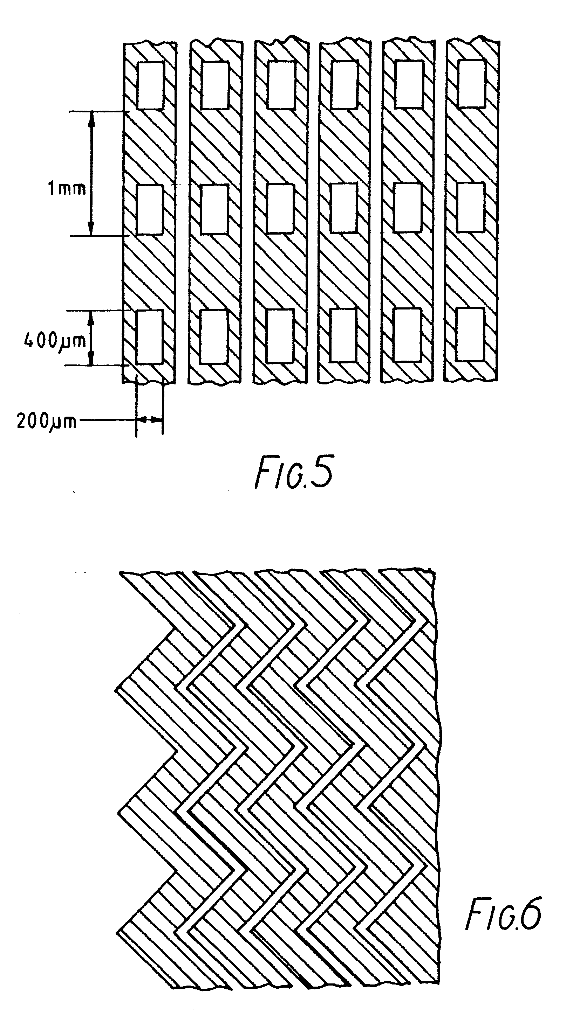

Figures 5, 6, 7 and 8 show X-electrode geometries in which further positional information is generated when the stylus motion is purely in the Y-direction. Figure 5 shows a linear pattern of X-coordinate electrodes with rectangular central holes of dimensions 200 microns by 400 microns on a pitch of 1 mm. Motion of the stylus in the Y-coordinate direction results in the generation and cancellation of piezoelectric charge at a frequency determined by the pitch p of the holes and the velocity v of the stylus. This frequency will be chosen to exceed the reciprocal charge-integration time. Thus, additional X-information will be generated at intervals of v/p seconds. The pitch, position and geometry of the holes will be selected for optimum performance. If the stylus is located in-between the electrodes, however, then its X-position may still not be locateable during pure Y-direction motion.

Figure 6 shows a uniform zig-zag pattern of interlaced X-coordinate electrodes. Motion of the stylus in the Y-coordinate direction results in the generation and cancellation of piezoelectric charge at a frequency determined by the quotient of the pitch p of the zig-zag and the velocity of the stylus. This frequency will be chosen, as in the previous example, to exceed the reciprocal charge-integration time. The zig-zag pattern has the advantage that a linear motion of the stylus in the Y-direction results in a regular intersection of the stylus with the electrode strip, generating additional X-positional information.

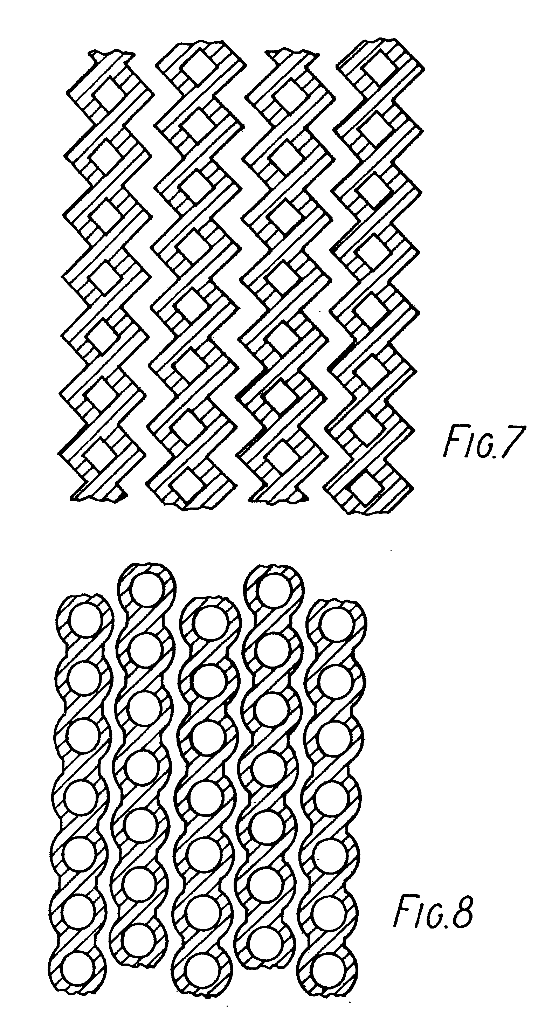

Figures 7 and 8 show alternative geometries which combine those of Figures 5 and 6. It is considered that the interlaced "diamond" pattern of Figure 7 has particular advantages whilst the interlaced combination of lines and annular shapes in Figure 8 has the advantage in respect of ease of processing by standard screen-printing or photolithographic techniques.

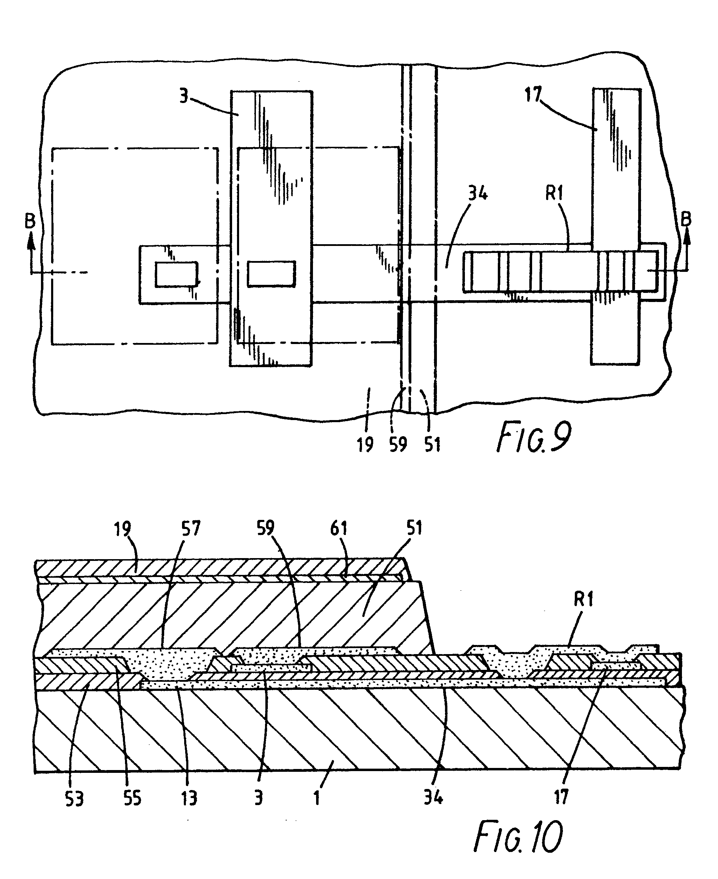

Referring now to Figures 9 and 10, the second device to be described is an adaptation of the first device and thus corresponding components are correspondingly labelled. The second device differs from the first device however in that the two piezoelectric layers 5, 11 of the first device are replaced by a single piezoelectric layer 51 thus simplifying fabrication. This second device is fabricated as follows:

A first metal layer is formed on substrate 1 by screen-printing or other suitable means, forming the X-coordinate electrode structure 13, the Y-coordinate output buses (not shown) and appropriate edge-connectors (not shown). A first insulator layer 53 is then formed by screen-printing or other suitable means. Connection holes are exposed over the X-axis electrode extensions 34 and Y-coordinate output busbar array for connection to subsequently deposited resistor elements R1. A second metal layer is then formed, creating the Y-coordinate electrode structure 3, the X-coordinate output busbar array and appropriate edge-connectors (not shown). A second insulator layer 55 is then formed and connection holes exposed over the Y-coordinate electrode extensions 32 and the X-coordinate output busbar array. Thick-film resistors R1 are then printed so as to link the X and Y electrode extensions to their respective output buses in the binary-weighted format described in relation to the first device. Respective metal electrode areas 57, 59 for the X and Y sections of each array of sensing electrodes 13, 3 are formed to assist in planarizing the back contacts to the subsequent layer of piezoelectric material 51. Optionally, an insulating overlayer (not shown) may be added where appropriate to seal the resistor surfaces and thus provide protection for the resistors R1.

A gold layer (not shown) may suitably be formed over the edge-connector contacts (not shown) to reduce their contact resistance. It will be noted that at this stage, the fabrication steps could have been standard thick-film processes; an outline only has been given for clarity (e.g. cleaning and firing stages etc. have not been listed). The metal-layer types are not critical; epoxy or polyimide would be suitable for the insulator films. The piezoelectric copolymer layer 51 typically 100 microns to 300 microns thick is then formed over the matrix of electrode "pairs" 3, 13 and an upper metal layer 61 is formed over the piezoelectric layer 51 only (i.e. kept clear of the edge). The piezoelectric material 51 is then poled by standard techniques. A final, thin protective layer 19 of epoxy for example is formed over the surface of the sensing area of the device. The underlying pressure-sensing structure (not shown in Figures 9 and 10) is then attached as in the first device.

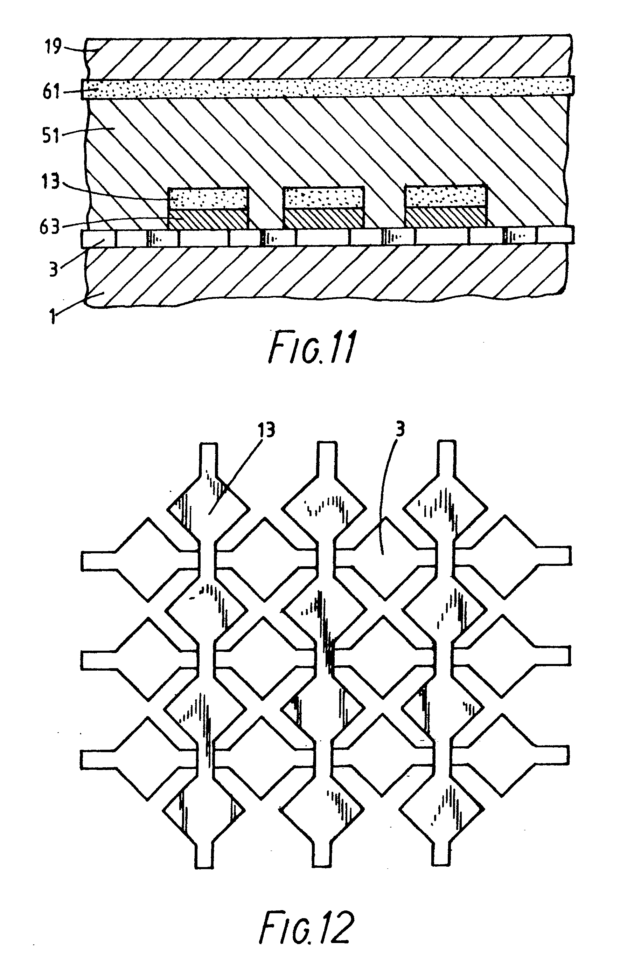

Figures 11 and 12 illustrate a preferred construction of the single-layer device described in relation to Figures 9 and 10.

A lower, Y-electrode array 3 is etched on a rigid PCB substrate 1. The array consists typically of 63 copper electrodes on a pitch of 0.5 mm. The electrodes are typically 30 micron thick. A possible shape of the Y-electrode array 3 is shown in the plan view of Figure 12. The shape of the electrode is chosen to reduce the capacitance between X- and Y-arrays.

A flexible PCB is used for the upper X-electrode array 13. The X-electrode array 13 typically consists of 127 copper electrodes on a 0.5 mm pitch, etched from a 20 micron copper layer on a 30 micron thick "flexible" polyimide substrate 63. The flexible PCB is bonded using a suitably thin (e.g. 5 micron) adhesive layer to the rigid PCB array with the electrode pattern uppermost (i.e. on the outer surface). A possible shape of the X-electrode is shown in Figure 12. The shape of the X-array, and of its location with respect to the Y-array is chosen to minimize the electrical capacitance between these two arrays.

An optional etching process stage could be used to remove the exposed regions of the flexible PCB support layer 63, as shown in Figure 11.

A single piezoelectric layer 51 of typical thickness 300 microns is formed on the surface of the uppermost (X) array 13 by (for example) hydrostatic compression of an uncured composite of lead titanate powder and epoxy resin. Alternatively the piezoelectric layer could be a pre-poled polyvinylidene fluoride sheet, or a layer of VDF/TrFE copolymer deposited by screen-printing of solution-casting.

An earth electrode and screen 61, typically 1 - 10 microns is formed on the exposed (uppermost) surface of the piezoelectric layer 51 by screen-printing, electroplating, spray-painting of colloidal silver, or other suitable process. This earth electrode acts as the counter-electrode for both the X- and Y-electrode arrays in respect of the detection of piezoelectric charge.

A protective layer 19 typically 10 microns thick is carried on the exposed (uppermost) surface of the earth electrode screen. The protective layer encapsulates the whole device and protects the earth-electrode from wear by the action of the stylus.

As before, a piezoelectric pressure-sensing structure (not shown) may be added to the underside of the total assembly shown in Figures 7 and 8 in accordance with the earlier descriptions.

The single layer device has several advantages when compared with the two layer device described in relation to Figures 1 and 2. These include (i) ease of fabrication due to the fact that in the single layer device the processing of the substrate is virtually completed before incorporation of the piezoelectric layer 51, thus enabling the use of high temperature processes. These advantages, are, however, balanced by some reduction in signal in the single layer device compared to the double layer device, (ii) ease of electrical poling and (iii) ease of optimization of the layer thickness because of the similarity of the X- and Y- electrode arrays.

An important feature of any signature verification system is the capability of displaying the electronic data which is generated by the signature on a computer screen, LCD or other suitable instrument. This is so that a human operator can be seen to be in control of the verification process (and can intervene in borderline or difficult cases), and to "comfort" the user that the acquired information is truly representative of his or her signature. Furthermore, a visual depiction of the acquired signature information could be transmitted electronically for remote visual inspection. For example, the pressure sensitive device described herebefore may be employed to relay an electronic representation of a signature via standard telephone or cellular telephone links or facsimile lines for reforming into the recognised signature at the receiver end of the link. This utility may be further advanced to enable the real-time transmission of script by transferring the accumulated electronic signals derived from the pressure sensitive device into a buffer store and transmitting the contents of the buffer store via any of the above communications links. By utilising standard telephonic communication links, the pressure sensitive device lends itself to adaption within a standard telephone handset or the like.

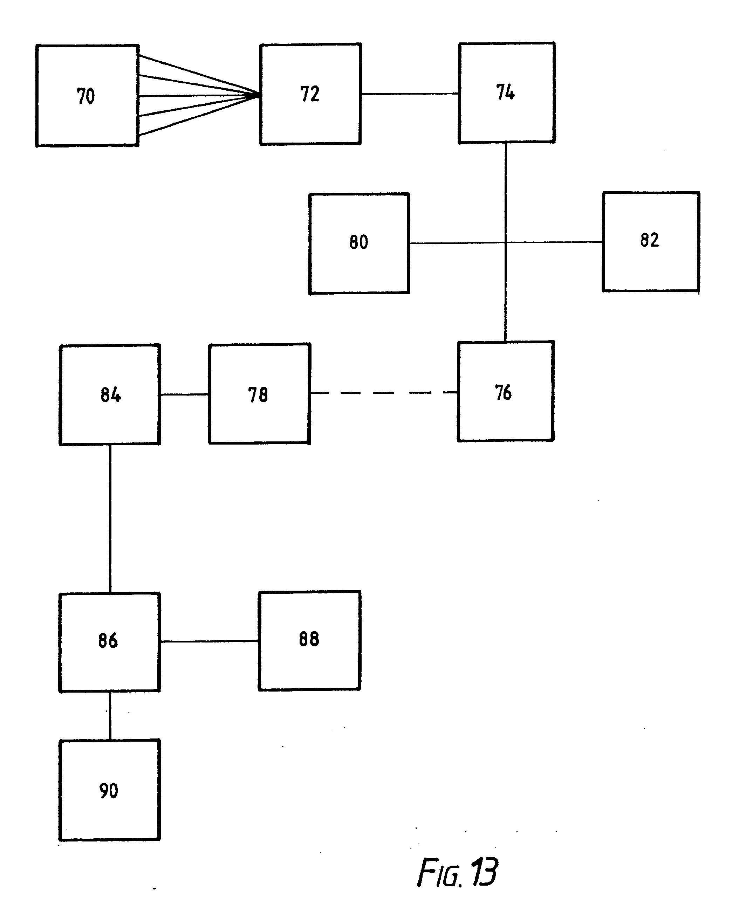

This is illustrated with reference to Figure 13. The pressure sensitive device is shown generally as 70 which, during operation supplies signals to a processing unit 72 which is in turn connected to a buffer store 74. The information held within buffer store 74 is then transmitted over the standard telephonic communication links via modems 76, 78. It is possible to view the information to be transmitted by way of a liquid crystal display 80 and/or hard copy printer 82.

On reception of the transmitted data, modem 78 transfers the data to a further buffer 84 from where the data is carried to a further processor 86 for display via a conventional facsimile hard copy display 88 and/or a visual display unit 90.

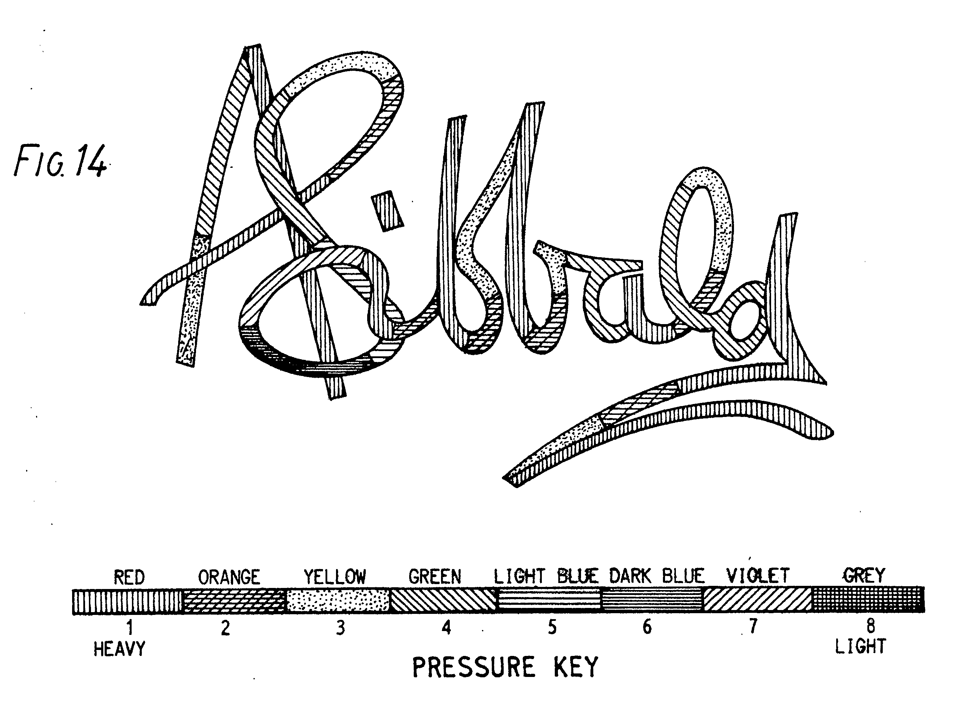

Referring now to Figure 14, the information may be displayed by recording the pressure of the stylus during the writing of the signature. This information is then quantized into, for example, eight pressure ranges, and the quantum number is used to colour-code the displayed signature. For example, heavy pressure would generate a red line, and light pressure would generate a violet line, with spectrally appropriate intermediates for the intermediate ranges (e.g. in all: red, orange, yellow, light green, dark green, light blue, dark blue and violet).

The signature could be printed in this coloured form on to identity or credit cards, and would provide a visually assessable element of information in addition to the x-y spatial data. The added information would increase the assessable information content by 50%.

In circumstances where a potential forger might benefit from the sight of the chromatically-encoded signature, it could be depicted on the card in black-and-white only, but stored in full electronically for display in a coloured format to authorised personnel only, via a secure verification terminal system.

It will be appreciated that the chromatic encoding could be based on the acceleration of the stylus tip, rather than its pressure.

Furthermore the width of the displayed line could also be used to display the pressure or acceleration information. This format would be much more restricted, however, owing to the limited range of acceptable linewidths and the difficulty in visually assessing their differences. Linewidth encoding could be implemented simultaneously with chromatic encoding (e.g. for pressure and acceleration data respectively).

It will be appreciated that many other materials, other than those described above, may be used in a device in accordance with the invention. In particular the substrate 1 may be formed from any insulating material which has smooth surfaces suitable for photolithographic screen-printing or other processes. Alternative piezoelectric materials include ceramic ferroelectric materials as for example described in Hydrid Circuits 14, 71 (1987) "Screen Printing Piezoelectric Devices", or alternatively composite piezoelectric materials such as lead zirconate titanate (PZT) in a silicone rubber matrix.

## Claims

1. A pressure sensitive device comprising: a piezoelectric member; at least one coordinate electrode structure carried on the member, each electrode structure comprising an array of strips; a common electrode structure carried by the member; and data collection means comprising a plurality of busbars providing electrical connections to selected ones of the strips such that the coordinates of a point pressure applied on the device may be determined by piezoelectrical signals derived from the busbars.

2. A device according to claim 1 comprising first and second coordinate electrode structures, the strips within each of the coordinate electrode structures being parallel, the strips of the first and the strips of the second coordinate electrode structures extending in different directions over the member.

3. A device according to claim 1 or 2 wherein the busbars are connected to the selected strips via a selection of resistive members for providing binary-weighted signals for determining the coordinates of the point pressure.

4. A device according to any one of the preceding claims wherein the piezoelectric member comprises two superimposed piezoelectric layers, each carrying one of the first and second coordinate electrode structures.

5. A device according to any one of claims 1 to 3 wherein the piezoelectric member comprises a single piezoelectric layer.

6. A device according to any one of the preceding claims further including determining means for determining the magnitude of the point pressure from the piezoelectric signals.

7. A device according to claim 6 wherein the determining means for determining the magnitude of the point pressure from the piezoelectric signals comprises a pressure pad.

8. A device according to any one of the preceding claims including a further piezoelectric member, with a third electrode structure carried by the further member, the further member being arranged to produce piezoelectric signals representative of the magnitude of the point pressure.

9. A pressure sensitive device according to any one of the preceding claims further comprising a buffer store for storing piezoelectrical signals derived from the busbars for transmission via a communication system.

*FIG.1*

*FIG.2*

BINARY-FORMAT
ANALOGUE..OUTPUTS

SENSING ELECTRODES
3 OR 13

FIG.3

EP 0 441 567 A2

FIG.4

11

1mm

400µm

200µm

*FIG.5*

*FIG.6*

FIG.7

FIG.8

FIG. 9

FIG. 10

FIG.11

FIG.12

FIG. 13

FIG. 14

| RED | ORANGE | YELLOW | GREEN | LIGHT BLUE | DARK BLUE | VIOLET | GREY |
|-----|--------|--------|-------|------------|-----------|--------|------|
| 1 | 2 | 3 | 4 | 5 | 6 | 7 | 8 |
| HEAVY | | | | | | | LIGHT |

PRESSURE KEY